# EUROPÄISCHE PATENTANMELDUNG

(11) **EP 2 306 496 A2**
(43) Veröffentlichungstag der Anmeldung: **06.04.2011**
(21) Anmeldenummer: 10186245.6
(22) Anmeldetag: 17.12.2004
(51) Int. Cl.: H01L 21/00

(54) **Verfahren und Vorrichtung zum Ablösen eines auf eine flexible Folie geklebten Bauteils**

(30) Priorität: 19.05.2004 CH 8692004
(62) Teilanmeldung aus: 04804931.6
(71) Anmelder: Kulicke & Soffa Die Bonding GmbH, 8572 Berg TG (CH)
(72) Erfinder: Trinks, Joachim, 9230, Flawil (CH); Marte, Andreas, Steinach (CH); Herbst, Wolfgang, Konstanz (DE)

(57) **Zusammenfassung**

Es wird ein Ablösewerkzeug (5) offenbart, auf welches eine Folie (2) mit einem abzulösenden Bauteil (1) platziert wird, wobei das Ablösewerkzeug (5) über wenigstens ein in einer Stützebene (11) verlaufendes Stützelement (6) für die Folie verfügt. Die Folie wird mittels Unterdruck sowohl gegen das Stützelement (6) als auch teilweise unter die Stützebene gesaugt. Im Bereich des Stützelements ist wenigstens ein Flächenabschnitt (8) vorgesehen, der zu Beginn des Ablösevorgangs in der Stützebene verläuft und der nach dem Erfassen des Bauteils (1) mit einem Saugwerkzeug (4) unter Aufrechterhaltung des Unterdrucks planparallel zur Stützebene bewegt werden kann. Dadurch kann der Ablöseprozess der Folie in einer geführten Bewegung gesteuert werden, ohne dass eine Beschädigung oder Verschiebung des Bauteils stattfindet.

## Beschreibung

Die Erfindung betrifft eine Vorrichtung zum Ablösen eines auf eine flexible Folie geklebten Bauteils gemäss der Beschreibung in den Absätzen [0057] bis [0066]. Derartige Vorrichtungen dienen namentlich bei der Verarbeitung von Halbleiterchips dazu, eine Vielzahl von Chips in rascher Folge von der Waferfolie abzunehmen und auf eine Unterlage zu platzieren.

Die Halbleiterchips mit den darauf angeordneten elektronischen Schaltkreisen werden dabei vorher aus der als Wafer bezeichneten Siliciumscheibe durch Sägen vereinzelt. Der Wafer wird spätestens für den Sägeprozess auf die in einem Rahmen gespannte Waferfolie geklebt, wobei die Haftung ersichtlicherweise ausreichend hoch sein muss, um Ausbrüche oder Chipablösungen beim Sägeprozess zu verhindern. Dagegen sollte beim Ablösen der einzelnen Chips von der Folie die Haftung so klein wie möglich sein, um übermässige mechanische Krafteinwirkungen auf den Chip zu vermeiden.

Es sind bereits Verfahren und Vorrichtungen bekannt, bei denen der Ablöseprozess durch gegen die Folie pressbare Nadeln oder Stössel unterstützt wird. Gemäss einem anderen Ablöseverfahren wird die Folie in eine Stützunterlage mit einer Mehrzahl von Vertiefungen gesaugt, sodass sich die Haftfläche an den Bauteilen erheblich verringert und die erforderliche Ablösekraft dadurch reduziert werden kann. Beispiele für derartige Verfahren sind in der US 4 778 326 oder in der US 6 202 292 beschrieben. Schliesslich ist durch die US 6 561 743 auch ein gattungsmässig vergleichbares Verfahren bekannt geworden, bei dem eine Stufe lateral in der Ebene der Folie verschoben wird. Dabei wird die Folie gleichzeitig auf eine tiefere Ebene der Stufe angesaugt, sodass während des Vorschubs der Stufe die Folie kontinuierlich vom Bauteil abgezogen wird.

Die US 2003/0075271 beschreibt ein Verfahren und Vorrichtung zum Ablösen von Halbleiterelementen, bei der ein Ablösewerkzeug mehrere umlaufende, konzentrisch zueinander angeordnete Kontaktelemente aufweist, welche der Reihe nach teleskopartig ausfahrbar sind, wobei das Halbleiterelement angehoben wird und sich die Folie stufenweise ablöst.

Gemäss JP 2001-196443 verfügt das Ablösewerkzeug über eine pyramidenartig strukturierte Saugfläche. Diese Saugfläche ist von einer ebenen Auflagefläche umgeben.

Die JP 63-228638 beschreibt ein Ablösewerkzeug, bei dem ein Stössel mit einer kleineren Fläche als das elektronische Bauteil von unten gegen die Folie gepresst wird. Die Haltevorrichtung zum Ergreifen des Bauteils ist gabelartig ausgebildet und erfasst das Bauteil in dem bereits von der Folie abgelösten Randbereich.

Schliesslich beschreibt die JP 3-76139 ein Ablösewerkzeug für ein Halbleiterelement, bei dem ein Ablösestempel mit einer Nadel kombiniert ist, wobei zuerst der Ablösestempel angehoben und dann die Nadel durch die Folie gestossen wird.

Ein Problem bei allen bekannten Verfahren besteht darin, dass diese für die Verarbeitung von Chips mit einer sehr geringen Dicke von beispielsweise 0,05 mm nur beschränkt geeignet sind. Beim Abheben des Chips mit Nadeln oder Stösseln besteht die Gefahr einer mechanischen Beschädigung. Auch das unkontrollierte Ansaugen der Folie in Vertiefungen kann zu starken Biegekräften am Chip und damit zu bleibenden Schäden führen. Bei der verschiebbaren Stufe gemäss US 6 561 743 erfolgt die Ablösung von der Folie fortlaufend und damit asymmetrisch, was eine geringfügige Verschiebung nach einer Seite verursachen kann. Je nach Chipgrösse wird ausserdem seitlich ein entsprechender Spielraum für die Verschiebung benötigt, was zu Platzproblemen im Randbereich des Wafers führen kann.

Es ist daher eine Aufgabe der Erfindung, ein Verfahren der eingangs genannten Art zu schaffen, das auch die Ablösung von Bauteilen mit sehr geringer Dicke ermöglicht, ohne diese übermässig zu belasten. Das Verfahren sollte ausserdem einen hohen Grad an Betriebssicherheit aufweisen und möglichst unabhängig vom verwendeten Folientyp arbeiten. Diese Aufgabe wird erfindungsgemäss mit einem Verfahren gelöst, wie es in den Absätzen [0068] bis [0076] beschrieben ist.

Der planparallel verschiebbare Flächenabschnitt bewirkt eine sehr präzise Steuerung der Foliendeformation unter der Einwirkung des Unterdrucks zur Reduktion der Haftfläche. In Folge der vorzugsweise senkrecht zur Stützebene verlaufenden Bewegung kann eine vollständige Symmetrie des Ablöseprozesses erreicht werden. Der Hub der planparallelen Vorschuboder Rückzugsbewegung lässt sich exakt einstellen. Damit kann das Ablöseverfahren an bestimmte Werkstückparameter angepasst werden wie z. B. an bestimmte Folienqualitäten oder Bauteilhöhen. Auch die Geschwindigkeit des Ablösevorgangs lässt sich dabei steuern. Im Gegensatz zu den bekannten Verfahren wird das Bauteil bis zum endgültigen Abheben in jeder Sequenz der Ablösung entweder zwischen der Haltefläche des Haltewerkzeugs und dem Flächenabschnitt oder zwischen der Haltefläche und dem Stützelement klemmend gehalten. Eine derartige beidseitige und vorzugsweise flächige Unterstützung zu jedem Zeitpunkt ist besonders bei sehr dünnen Chips wichtig.

Für die endgültige Ablösung wird der Flächenabschnitt aus der Stützebene in eine Ablöseposition zurückgezogen, während das Haltewerkzeug das Bauteil festhält. Der Flächenabschnitt legt dabei mit einer einstellbaren Geschwindigkeit einen definierten Hub zurück und entfernt sich von der Folienunterseite. Unter der Vakuumeinwirkung folgt die Folie dem Steuerflächenabschnitt und löst sich dabei von der Unterseite des Bauteils ab, das nur noch durch das Stützelement abgestützt wird. Anschliessend kann das Bauteil von der noch durch das Stützelement gehaltene Verbindung abgelöst werden, wozu nur noch ein geringer Kraftaufwand erforderlich ist.

Gemäss einem etwas abgewandelten Verfahren kann der Flächenabschnitt zuerst aus der Stützebene simultan mit dem Haltewerkzeug über die Stützebene hinaus vorgeschoben und dann wieder in die Stützebene zurückgesetzt werden. Bei dieser Verschiebebewegung wird das Bauteil grossflächig abgestützt und zwischen dem Haltewerkzeug und dem Flächenabschnitt sicher und stabil gehalten. Beim Vorschieben des Flächenabschnitts wird der Ablösevorgang der Folie je nach Konfiguration des Flächenabschnitts auf sanfte Weise dem Rand entlang gestartet. Dazu ist es vorteilhaft, wenn der Flächenabschnitt bzw. die Summe der Flächenabschnitte eine etwas geringere Fläche als das Bauteil aufweist. Beim Zurücksetzen setzt der Flächenabschnitt seine Bewegung kontinuierlich weiter fort, bis er wiederum die eingangs erwähnte Ablöseposition erreicht hat.

Je nach Grösse des Bauteils können mehrere, zueinander beabstandete Flächenabschnitte simultan derart bewegt werden, dass wenigstens zwischen zwei Flächenabschnitten ein Stützelement angeordnet ist. Die beweglichen Flächenabschnitte sind dabei vom Stützelement durchsetzt, sodass in jeder Sequenz ein möglichst gut verteilte Abstützung des Bauteils an der Unterseite der Folie gewährleistet ist.

In bestimmten Anwendungsfällen kann es vorteilhaft sein, mehrere Flächenabschnitte unabhängig voneinander zu bewegen.

Die Abstützung der Folie am Stützelement erfolgt vorzugsweise punktförmig und/oder linienförmig, je nach Grösse und Konfiguration des Bauteils.

Weitere Vorteile können erreicht werden, wenn das Bauteil wenigstens zu Beginn des Ablösevorgangs durch den Flächenabschnitt bzw. durch die Flächenabschnitte an wenigstens 50% seiner Fläche abgestützt wird. Eine derartige grossflächige Abstützung ist vor allem dann wichtig, wenn das Bauteil zuerst aus der Stützebene heraus angehoben wird, wobei eine Randablösung beabsichtigt ist.

In speziellen Anwendungsfällen ist es vorteilhaft, wenn der Flächenabschnitt erwärmt wird. Auf diese Weise kann Wärme auf den Chip bzw. auf die Waferfolie übertragen werden. Die Temperatursteuerung ist dabei jeweils prozessabhängig.

Die Erfindung betrifft auch eine Vorrichtung gemäss der Beschreibung in den Absätzen [0057] bis [0066]. Mit dieser Vorrichtung soll sich einerseits das eingangs erwähnte Verfahren auf einfache Weise durchführen lassen. Die Vorrichtung soll sich ausserdem nach Möglichkeit in bestehende Verarbeitungsmaschinen, insbesondere in bestehende Die Bonder einbauen lassen.

Das beweglich gelagerte Steuerelement mit dem planparallel verschiebbaren Flächenabschnitt lässt sich besonders einfach mit dem gleichen Antriebssystem koppeln, wie es bereits für konventionelle Ablösenadeln vorhanden sein kann. Das Steuerelement kann dabei relativ zur Stützebene sowohl zurückziehbar als auch vorschiebbar sein. Bei sehr kleinen Chips kann es genügen, wenn die Steueroberfläche wenigstens einen ebenen Flächenabschnitt aufweist, neben dem auf geeignete Weise wenigstens ein Stützelement angeordnet ist. Vorteilhaft handelt es sich aber um mehrere Stützelemente, welche den Flächenabschnitt im geeigneten Abstand zueinander bzw. zum Flächenabschnitt umgeben. Dadurch, dass die Steueroberfläche mehrere zueinander beabstandete ebene Flächenabschnitte aufweist, wird eine grossflächige Abstützung auf der Unterseite der Folie gewährleistet. Wenn wenigstens zwischen zwei Flächenabschnitten ein Stützelement angeordnet ist, wird auch bei unter die Stützebene zurückgezogenen Flächenabschnitten eine weitestgehende Abstützung des Bauteils gewährleistet.

Je nach Geometrie des Bauteils kann das Steuerelement mehrere, fest miteinander verbundene Flächenabschnitte aufweisen. Dabei ist es besonders vorteilhaft, wenn das Steuerelement monolithisch hergestellt ist, sodass alle Flächenabschnitte gemeinsam bearbeitet werden können und somit auch exakt in der gleichen Ebene liegen.

Das Steuerelement kann aber auch mehrere, unabhängig voneinander bewegbare Flächenabschnitte aufweisen, die über ein entsprechendes Getriebe seitlich versetzt zueinander bewegbar sind.

Das Stützelement kann zur punktförmigen Auflage der Folie Stützpyramiden oder Stützkegel oder zur linienförmigen Auflage der Folie Stützleisten aufweisen.

Besonders vorteilhaft ist es ausserdem, wenn wenigstens vier Flächenabschnitte matrixartig nebeneinander angeordnet sind. Bei dieser, einem Kleeblatt ähnlichen Anordnung kann das Stützelement eine Mehrzahl von Stützpyramiden oder Stützkegel aufweisen, die ebenfalls matrixartig um die Flächenabschnitte angeordnet sind. Alternativ könnten auch ein Kreuz bildende Stützleisten zwischen den vier Flächenabschnitten angeordnet sein.

Die Steueroberfläche bzw. die einzelnen Flächenabschnitte können mittels einer Heizvorrichtung erwärmbar sein, um die Waferfolie bzw. den einzelnen Chip zu erwärmen. Bei der Heizvorrichtung kann es sich um eine elektrische Widerstandheizung oder um ein anderes Heizelement handeln. Die Heizvorrichtung kann ausserdem über geeignete Steuerungsmittel für die Temperatursteuerung verfügen.

Weitere Einzelmerkmale und Vorteile der Erfindung ergeben sich aus der nachfolgenden Beschreibung von Ausführungsbeispielen und aus den Zeichnungen. Es zeigen:
Figur 1 ein erstes Beispiel eines erfindungsgemässen Ablösevorgangs in drei Sequenzen,
Figur 2 ein zweites Beispiel eines erfindungsgemässen Ablösenvorgangs in vier Sequenzen,
Figur 3 eine Draufsicht auf die Stirnseite eines ersten Ablösewerkzeugs gemäss Erfindung,
Figur 4 einen Querschnitt durch die Ebene A-A gemäss Figur 3,
Figur 5 eine perspektivische Darstellung des Ablösewerkzeugs gemäss den Figuren 3 und 4,
Figur 6 eine Draufsicht auf die Stirnseite eines zweiten Ablösewerkzeugs gemäss Erfindung,
Figur 7 einen Querschnitt durch die Ebene B-B gemäss Figur 6,
Figur 8 eine perspektivische Darstellung des Ablösewerkzeugs gemäss den Figur 6 und 7,
Figur 9 einen Querschnitt durch ein weiteres Beispiel eines Ablösewerkzeugs mit mehreren unabhängig bewegbaren Flächenabschnitten, und
Figur 10 einen Ablösevorgang mit einem Ablösewerkzeug gemäss Figur 9 in den Sequenzen a bis k.

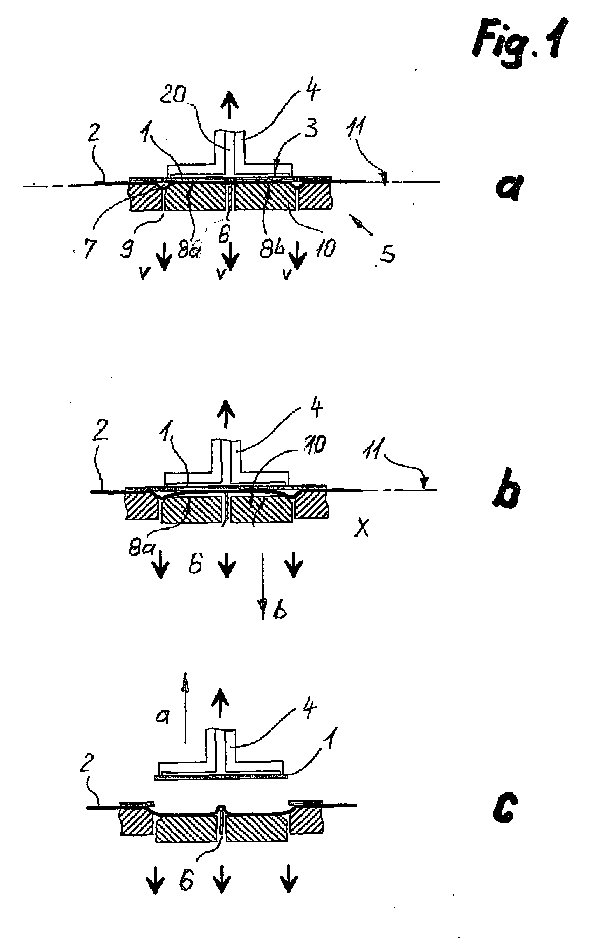

In den Figuren 1a bis 1c ist ein erstes Ausführungsbeispiel eines Ablösevorgangs in drei Sequenzen dargestellt. Dabei sind auf einer gespannten Waferfolie 2 eine Mehrzahl von Chips 1 aufgeklebt bzw. der ursprünglich aufgeklebte zusammenhängende Wafer wurde durch Sägen in einzelne Chips unterteilt. Nach dem Sägen wird die Folie auf bekannte Weise weitergespannt, um das Vereinzeln der Chips zu erleichtern. Das insgesamt mit 5 bezeichnete Ablösewerkzeug ist hier nur schematisch dargestellt. Es ist relativ zur Waferfolie 2 ortsfest in einer Arbeitsmaschine angeordnet. Die Platzierung des Chips 1 über dem Ablösewerkzeug 5 erfolgt über einen X-Y Koordinatenantrieb.

Ein Haltewerkzeug 4 mit einer ebenen Haltefläche wird mit Saugfunktion kann auf der von der Folie abgewandten Oberfläche 3 des Chips angelegt werden. Über einen Unterdruckkanal 20 wird ein Unterdruck auf diese Oberfläche angelegt, sodass der Chip am Haltewerkzeug 4 haftet. Das Haltewerkzeug 4 ist unter Aufrechterhaltung des Unterdrucks in Pfeilrichtung a abhebbar (Figur 1c) und transportiert den Chip auf ein Substrat oder an eine Zwischenstation.

Das Ablösewerkzeug 5 verfügt über wenigstens ein Stützelement 6, das in einer Stützebene 11 liegt. Auf dieser Stützebene liegt die Waferfolie 2 zu Beginn des Ablösevorgangs plan auf. In der Stützebene 11 verlaufen auch vorzugsweise mehrere am Ende eines Steuerelements 10 angeordnete Flächenabschnitte 8a, 8b in unmittelbarer Nachbarschaft des Stützelements 6. Die Flächenabschnitte bzw. das Steuerelement 10 sind in Pfeilrichtung b zurückziehbar (Figur 1b).

Während des gesamten Ablösevorgangs liegt im Bereich des Ablösewerkzeugs 5 an der Unterseite der Waferfolie 2 ein Unterdruck an (Pfeile v). Dieser kann über spezielle Unterdruckkanäle 9 oder einfach nur über das Spiel zwischen den festen und beweglichen Teilen an der Folie angreifen. Im Randbereich der Flächenabschnitte 8 können beispielsweise durch entsprechende Anschrägungen Vertiefungen 7 ausgebildet sein, an denen unter der Einwirkung des Unterdrucks der Ablöseprozess eingeleitet werden kann.

Eine derartige Startphase ist in Figur 1a dargestellt. Die Vertiefungen 7 verlaufen nicht nur im Randbereich der Flächenabschnitte 8a, 8b, sondern auch im Randbereich des Chips 1. Sie bewirken, unter der Einwirkung des Unterdrucks eine örtlich sehr begrenzte Deformation der Waferfolie 2 und damit deren Ablösung vom Chip 1.

In einem nächsten Schritt gemäss Figur 1b werden die Flächenabschnitte 8a, 8b relativ zur Stützebene 11 in Pfeilrichtung b zurückgezogen. Die Waferfolie 2 folgt kontinuierlich dieser Bewegung und verbleibt nur im Bereich der Abstützung durch das Stützelement 6 in der Stützebene 11. Die Ablösegeschwindigkeit kann dabei mittels der Bewegung der Flächenabschnitte exakt gesteuert werden. Das Haltewerkzeug 4 hält den Chip 1 unbeweglich in der Ausgangsposition.

Erst wenn gemäss Figur 1c die Waferfolie 2 ihre vollständige Deformation erreicht hat und nur noch am Stützelement 6 aufliegt, bzw. im Bereich dieser Abstützung am Chip 1 haftet, beginnt das Abheben des Chips in Pfeilrichtung a mit Hilfe des Haltewerkzeugs 4. Nach dem Abheben wird unter der Waferfolie wieder Atmosphärendruck hergestellt und die Folie wird zum Abheben des nächsten Chips verschoben.

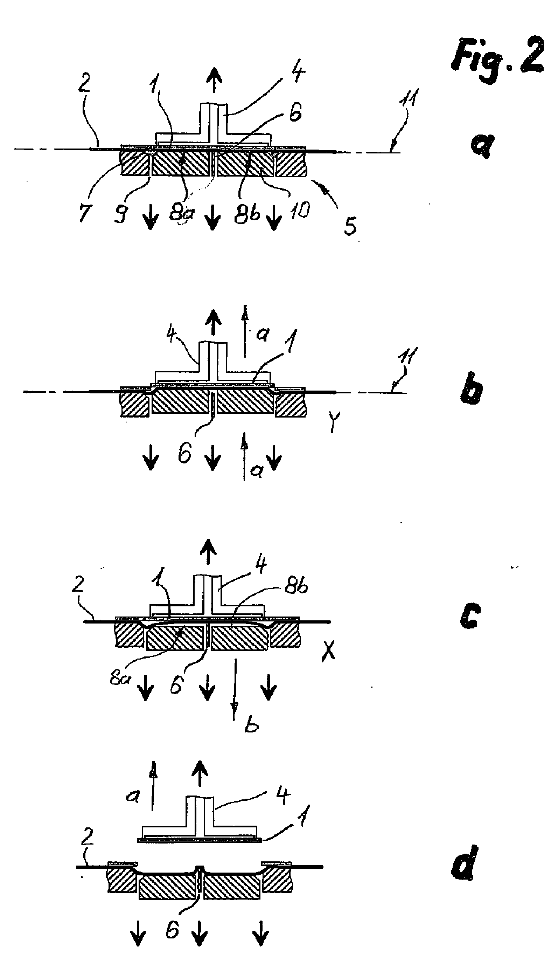

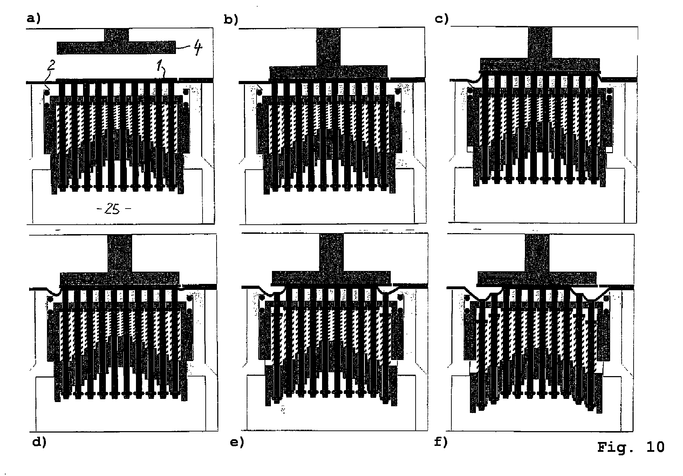

In den Figuren 2a bis 2d ist ein etwas modifiziertes Ablöseverfahren dargestellt. Dabei entspricht die Figur 2a teilweise der Ausgangssituation gemäss Figur 1a. Die Folie 2 ist jedoch flach über die Vertiefungen 7 gespannt, so dass der Ablöseprozess an dieser Stelle noch nicht einsetzt. Ausserdem entsprechen die Figuren 2c und 2d in der Endphase des Ablösevorgangs den Situationen gemäss den Figuren 1b und 1c. Zur Einleitung des Ablöseprozesses ist jedoch ein weiterer Schritt gemäss Figur 2b dazwischen geschaltet. Dabei werden die Flächenabschnitte 8a, 8b simultan mit dem Haltewerkzeug 4 um eine geringe Distanz in Pfeilrichtung a vorgeschoben, sodass der abzulösende Chip 1 zunächst die Stützebene 11 überragt. Durch diesen minimalen Versatz wird der Ablösevorgang im Randbereich des Chips 1 auf sanfte Weise gestartet. Anschliessend wird das Haltewerkzeug 4 mit den Flächenabschnitten 8a, 8b wiederum synchron abgesenkt, bis die Folie 2 wieder auf der Abstützung 6 aufliegt. Die Flächenabschnitte 8a, 8b setzen ihre Bewegung gemäss Figur 2c in Pfeilrichtung b fort, worauf sich der restliche Ablösevorgang wie gemäss Figur 1 abspielt.

Bei beiden Ablöseoperationen gemäss Figur 1 und Figur 2 wird in jedem Fall der Chip 1 zuerst mit Hilfe des Haltewerkzeugs 4 angefasst, bevor sich die Flächenabschnitte 8a und 8b nach oben bzw. nach unten bewegen. Dadurch wird der Chip zwischen der Haltefläche des Haltewerkzeugs und den Flächenabschnitten 8a, 8b bzw. dem Stützelement 6 klemmend erfasst, bevor überhaupt irgendwelche Zugoder Biegekräfte auf die Folie 2 einwirken. Bei Anheben der Flächenabschnitte 8a, 8b gemäss Figur 2 bleibt diese klemmende Halterung erhalten.

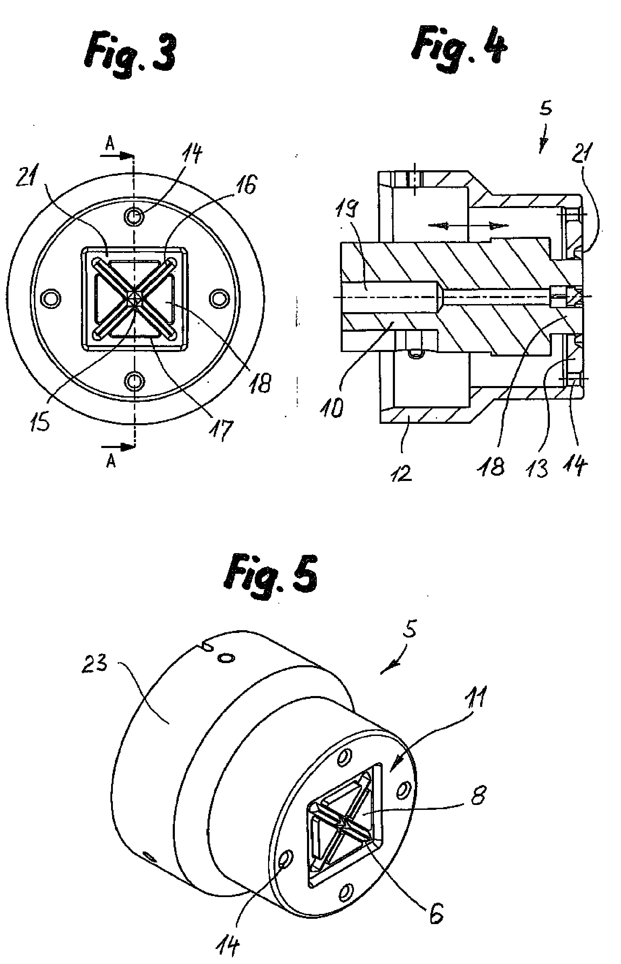

In den Figuren 3 bis 5 ist ein Ablösewerkzeug 5 dargestellt, wie es für die vorgängig beschriebenen Verfahren eingesetzt werden kann. Das Werkzeug besteht aus einem topfartigen Gehäuse 23 mit einer hohlzylindrischen Befestigungsmanschette 12 und mit einer Supportfläche 13, auf welcher die Folie im Umgebungsbereich des abzulösenden Chips zu liegen kommt. Die gesamte Innenseite der Befestigungsmanschette kann an eine Unterdruckquelle angeschlossen werden. Damit kann beispielsweise ein Unterdruck von 200 mbar absolut gegenüber dem Atmosphärendruck erzielt werden. Auf der kreisförmigen Supportfläche 13 sind in gleichmässiger Winkelteilung insgesamt vier Saugbohrungen 14 angeordnet, über welche die Waferfolie fixiert wird.

Auf der Supportfläche 13 ist eine etwa quadratische Absenkung 21 angeordnet. Innerhalb dieser Absenkung sind in kleeblattartiger Anordnung vier etwa dreieckige Stösselöffnungen 17 vorgesehen. Zwischen diesen Stösselöffnungen verläuft ein Stützleistenkreuz 16 und im Kreuzungspunkt ist eine Stützpyramide 15 angeordnet. Stützpyramide und Stützleistenkreuz bilden gemeinsam das Stützelement 6, das in der Stützebene 11 verläuft.

Im Zentrum und koaxial zur Befestigungsmanschette 12 ist ein etwa zylindrisches Steuerelement 10 axial beweglich gehalten. An einem Ende dieses Steuerelements sind vier Einzelstössel 18 angeordnet, deren Konfiguration in der Stützebene 11 der Konfiguration der Stösselöffnungen 17 entspricht. Die Stössel 18 weisen an ihren Enden je einen Flächenabschnitt 8 auf und sie durchdringen die Stösselöffnungen 17 mit Spiel, sodass auch entlang ihren Seitenwänden der Unterdruck auf die über der Vertiefung 21 liegende Waferfolie einwirken kann. Zu diesem Zweck kann auch im Zentrum des Steuerelements 10 eine Saugbohrung 19 angeordnet sein.

Beim vorliegenden Ausführungsbeispiel ist die Grundrissfläche des abzulösenden Chips geringfügig grösser als diejenige der einstückig ausgebildeten Stösselanordnung. Die Abstützung erfolgt über die Diagonalen des Chips und im Zentrum.

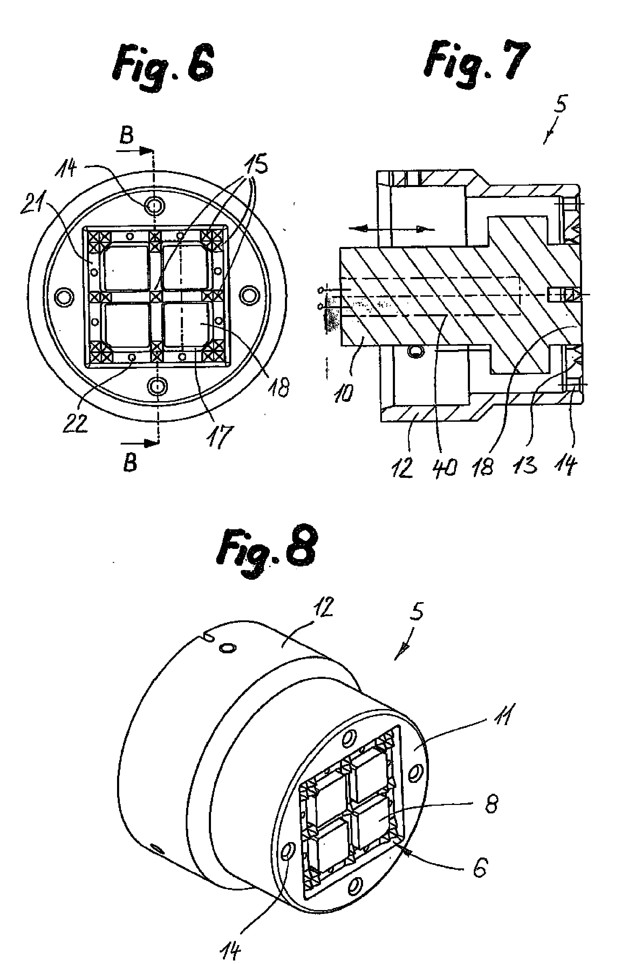

Beim Ablösewerkzeug gemäss den Figuren 6 bis 8 ist die Befestigungsmanschette 12 im Wesentlichen ähnlich ausgebildet wie beim vorhergehenden Ausführungsbeispiel. Auch die Saugbohrungen 14 in der Supportfläche 13 sind identisch angeordnet. Unterschiedlich ist jedoch die Konfiguration der Supportfläche selbst sowie des Steuerelements 10. Auch hier ist zwar eine quadratische Absenkung 21 vorgesehen. Das Stützelement 6 wird jedoch ausschliesslich durch Stützpyramiden 15 gebildet, die jeweils im Eckbereich, in der Mitte jeder Seitenkante und im Zentrum matrixartig angeordnet sind. Insgesamt vier ebenfalls etwa quadratische Stösselöffnungen 17 sind im Boden der Absenkung 21 angeordnet. Im Randbereich können Zusatzbohrungen 22 zur besseren Verteilung des Unterdrucks vorgesehen sein.

Die Steueroberfläche bzw. die einzelnen Flächenabschnitte sind mittels einer Heizvorrichtung 40 heizbar, die hier als elektrische Heizpatrone angedeutet ist.

Das Steuerelement 10 weist ebenfalls vier Stössel 18 auf, deren Konfiguration etwa derjenigen der Stösselöffnungen entspricht.

Bei diesem Ausführungsbeispiel wird die Waferfolie im Bereich des aufgeklebten Chips ausschliesslich punktförmig abgestützt. Im Übrigen ist die Funktion des Ablösewerkzeugs jedoch gleich wie beim vorgehend beschriebenen Ausführungsbeispiel.

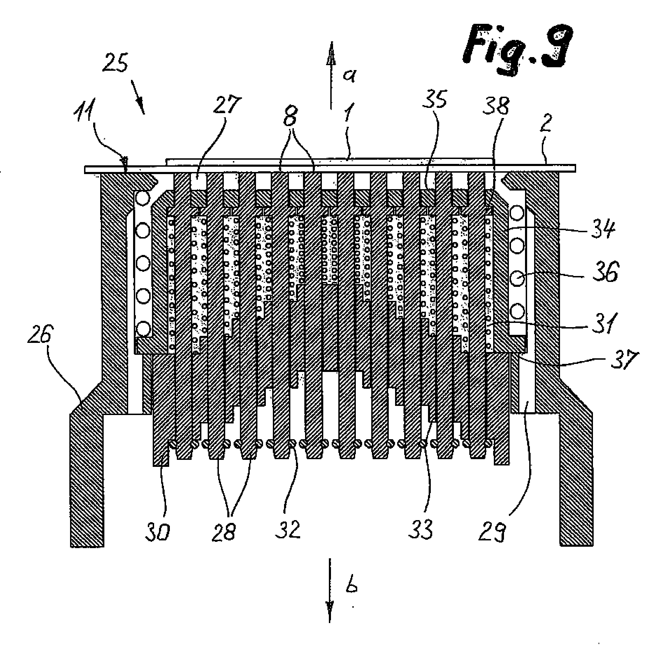

Figur 9 zeigt schliesslich noch ein abgewandeltes Ausführungsbeispiel eines Ablösewerkzeugs 25. Dieses verfügt über ein Gehäuse 26, in welchem möglicherweise matrixartig mehrere Einzelstössel 28 axial verschiebbar gelagert sind. Die Lagerung der Einzelstössel erfolgt sowohl in einem Steuerschieber 30 als auch in einem Vorschubelement 34. Das Vorschubelement ist ähnlich wie das Gehäuse 26 topfartig ausgebildet und verfügt über eine Stirnseite 35, die etwas zurückversetzt unter einer Gehäuseöffnung 27 liegt. In der Stirnseite 35 sind Öffnungen angeordnet, durch welche die Einzelstössel 28 dringen.

Das Vorschubelement 34 wird unter der Einwirkung einer Schraubendruckfeder 36 gegen eine Auflage 37 am Gehäuse 26 vorgespannt. Dagegen ist der Steuerschieber 30 in Pfeilrichtung b noch weiter absenkbar. Der Steuerschieber 30 verfügt über eine Abstufung 33 mit verschiedenen Ebenen, wobei jeweils zwei oder mehr Einzelstössel an der gleichen Abstufungsebene angeordnet sein können. Die Einzelstössel verfügen am oberen Ende über je einen Anschlag 38, der die Stösselbewegung nach oben begrenzt.

Am unteren Ende sind die Einzelstössel mit je einem Mitnehmerelement 32 versehen, wobei in der dargestellten neutralen Ausgangslage alle Mitnehmerelemente auf der gleichen Ebene liegen. Zwischen den Anschlägen 38 und der Abstufung 33 sind die Einzelstössel mit je einer Schraubendruckfeder 31 vorgespannt.

Der für den Ablöseprozess erforderliche Unterdruck kann über Unterdruckkanäle 29 an der Waferfolie 2 angreifen. Zusätzliche Kanäle, beispielsweise in den Einzelstösseln 28 wären jedoch denkbar.

In der dargestellten neutralen Ausgangslage liegen die Steuerflächenabschnitte 8 der Einzelstössel alle in der Stützebene 11. Die Besonderheit dieses Ausführungsbeispiels besteht darin, dass die Flächenabschnitte 8 gleichzeitig die Funktion einer Abstützung übernehmen. Das heisst, dass in der Stützebene 11 keine relativ zu den Flächenabschnitten 8 starre Abstützung vorhanden ist.

Bei einer Verschiebung des Steuerschiebers 30 in Pfeilrichtung a wird ersichtlicherweise das Vorschubelement 34 gegen die Kraft der Schraubendruckfeder 36 angehoben und die Einzelstössel bzw. deren Flächenabschnitte 8 werden durch die Öffnung 27 über die Stützebene 11 hinaus vorgeschoben. Die Kraft der Schraubendruckfedern 31 reicht dabei aus, um die Anschläge 38 in der Anschlagposition zu halten. Wird der Steuerschieber 30 jedoch in Pfeilrichtung b zurückgezogen, werden ersichtlicherweise über die Abstufung 33 zuerst die beiden äussersten Einzelstössel zurückgezogen. Anschliessend folgen ihnen paarweise von aussen nach innen weitere Stössel, bis zuletzt die beiden innersten Stössel zurückgezogen werden. Bei einer matrixartigen Anordnung der Stössel werden jeweils Stösselreihen konzentrisch von aussen nach innen zurückgezogen. Diese geführte Rückzugsbewegung bewirkt ein kontinuierliches Ablösen der Folie von aussen nach innen in einer geführten und abgestützten Bewegung. Die Ablösung erfolgt völlig symmetrisch, sodass keine Verschiebung des Chips stattfinden kann.

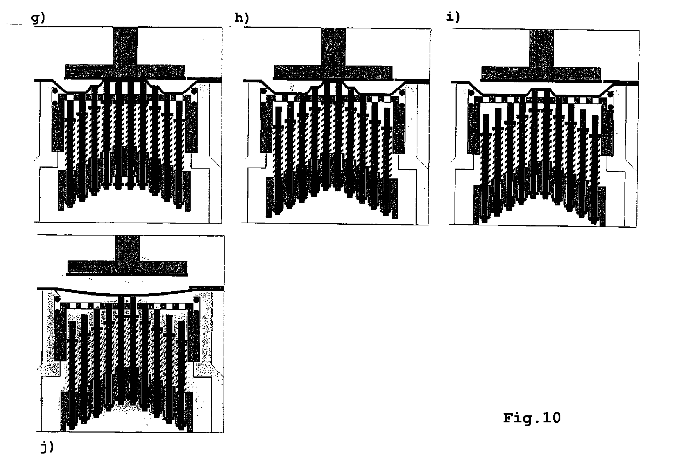

In Figur 10 ist in den Einzeldarstellungen a) bis k) eine Ablösesequenz unter Verwendung des Ablösewerkzeugs 25 gemäss Figur 9 dargestellt. a) zeigt dabei die neutrale Ausgangsstellung nach dem Platzieren der Waferfolie über dem Ablösewerkzeug und bevor das Haltewerkzeug 4 den Chip 1 erfasst.

Gemäss b) erfasst das Haltewerkzeug den Chip und die Unterseite der Waferfolie 2 wird unter Vakuum gesetzt.

Anschliessend wird gemäss c) der Steuerschieber 30 vorgeschoben, wobei sich die Flächenabschnitte 8 simultan mit dem Haltwerkzeug 4 anheben. Gleichzeitig wird die Waferfolie 2 etwas unter die Stützebene 11 gesaugt. Entlang den Aussenkanten des Chips 1 beginnt jetzt bereits der Ablöseprozess.

Anschliessend wird gemäss d) der Steuerschieber 30 wieder zurückgesetzt, sodass der Chip 1 wieder in die Ausgangslage zurückkehrt. Sämtliche Einzelstössel haben jetzt zunächst die Funktion einer Abstützung für die Waferfolie. Diese verbleibt aber entlang den Kanten in abgelöster Position.

Gemäss e) wird der Steuerschieber weiter zurückgezogen, wobei die beiden äussersten Stössel mitgenommen werden und sich absenken. Unter der Einwirkung des Unterdrucks folgt die Waferfolie in einer geführten Bewegung und löst sich von der Unterseite des Chips ab. Gemäss f), g) und h) folgen weitere Rückzugssequenzen der Stössel von aussen nach innen, bis zuletzt nur noch die beiden innersten Stössel als Abstützung dienen.

Gemäss i) werden schliesslich auch die innersten Stössel noch unter die Stützebene 11 abgesenkt, sodass der Ablöseprozess beendet wird, ohne dass das Haltewerkzeug 4 bewegt werden muss.

Erst jetzt erfolgt gemäss k) das Anheben des Haltewerkzeugs 4 und der Druckausgleich, sodass sich die elastische Waferfolie 2 wiederum entspannt. Die Einzelstössel können jetzt in die Ausgangsposition gemäss a) zurückgeschoben werden und die Waferfolie kann zum Ablösen eines neuen Chips über dem Ablösewerkzeug positioniert werden. Selbstverständlich wären Abwandlungen des Ablösewerkzeugs gemäss Figur 9 denkbar. Insbesondere die Stösselanordnung und die Sequenzen des Rückzugs könnten jeweils den speziellen Gegebenheiten angepasst werden. Es wäre auch denkbar, zwischen den beweglichen Stösseln noch einzelne starre Abstützungen bzw. Stützelemente vorzusehen, die ebenfalls matrixartig angeordnet sein könnten.

Die vorstehend beschriebene Vorrichtung und weitere vorteilhafte Ausgestaltungen derselben können durch einen oder mehrere der nachfolgenden Absätze [0068] bis [0076] charakterisiert werden.

Vorrichtung zum Ablösen eines auf eine flexible Folie (2) geklebten Bauteils (1), insbesondere eines auf eine Waferfolie geklebten Halbleiterchips, mit einem Haltewerkzeug (4) zum Erfassen des Bauteils an seiner von der Folie abgewandten Oberfläche (3) und zum Abheben von der Folie, mit einem Ablösewerkzeug (5), auf das die Folie (2) im Bereich des Bauteils derart platzierbar ist, dass sie in einer Stützebene (11) aufliegt und in der Stützebene durch wenigstens ein Stützelement (6) abstützbar ist, sowie mit wenigstens einem sich gegen die Stützebene öffnenden Unterdruckkanal (9), wobei im Ablösewerkzeug wenigstens ein Steuerelement (10) mit einer Steueroberfläche derart beweglich gelagert ist, dass die Steueroberfläche aus der Stützebene (11) planparallel verschiebbar ist, dadurch gekennzeichnet, dass die Steueroberfläche wenigstens einen ebenen Flächenabschnitt (8) aufweist neben dem wenigstens ein Stützelement angeordnet ist.

Vorrichtung nach Absatz [0057], dadurch gekennzeichnet, dass der Flächenabschnitt (8) aus der Stützebene (11) in eine Ablöseposition (X) im Abstand zur Stützebene zurückziehbar ist.

Vorrichtung nach Absatz [0057] oder [0058], dadurch gekennzeichnet, dass der Flächenabschnitt (8) simultan mit dem Haltewerkzeug (4) über die Stützebene (11) hinaus vorschiebbar ist.

Vorrichtung nach einem der Absätze [0057] bis [0059] , dadurch gekennzeichnet, dass die Steueroberfläche (10) mehrere, zueinander beabstandete Flächenabschnitte (8) aufweist und dass wenigstens zwischen zwei Flächenabschnitten (8a, 8b) ein Stützelement (6) angeordnet ist.

Vorrichtung nach Absatz [0060], dadurch gekennzeichnet, dass die Flächenabschnitte (8a, 8b) fest miteinander verbunden sind.

Vorrichtung nach Absatz [0060], dadurch gekennzeichnet, dass die Flächenabschnitte, unabhängig voneinander bewegbar sind.

Vorrichtung nach einem der Absatz [0061] oder [0062] , dadurch gekennzeichnet, dass wenigstens vier Flächenabschnitte matrixartig nebeneinander angeordnet sind.

Vorrichtung nach einem der Absätze [0057] bis [0063] , dadurch gekennzeichnet, dass das Stützelement (6) punktförmige und/oder linienförmige Auflagen für die Folie aufweist.

Vorrichtung nach Absatz [0064], dadurch gekennzeichnet, dass das Stützelement eine Mehrzahl von Stützpyramiden oder Stützkegel aufweist, die matrixartig um den Flächenabschnitt bzw. die Flächenabschnitte angeordnet sind.

Vorrichtung nach einem der Absätze [0057] bis [0065] , dadurch gekennzeichnet, dass die Steueroberfläche mittels einer Heizvorrichtung (40) erwärmbar ist.

Das weiter oben beschriebene Verfahren und weitere vorteilhafte Ausgestaltungen desselben können durch einen oder mehrere der nachfolgenden Absätze [0068] bis [0076] charakterisiert werden.

Verfahren zum Ablösen eines auf eine flexible Folie (2) geklebten Bauteils (1), insbesondere eines auf eine Waferfolie geklebten Halbleiterchips, wobei das Bauteil an seiner von der Folie abgewandten Oberfläche (3) mit einem Haltewerkzeug (4) an einer ebenen Haltefläche erfasst und von der Folie abgehoben wird, wobei die Folie (2) im Bereich des Bauteils (1) derart auf ein Ablösewerkzeug (5) platziert wird, dass sie in einer Stützebene (11) aufliegt und in der Stützebene durch wenigstens ein Stützelement (6) abgestützt wird, und wobei die Folie mittels Unterdruck sowohl gegen das Stützelement (6), als auch teilweise unter die Stützebene (11) gesaugt wird, und wobei ferner wenigstens ein Steuerelement (10) mit einer Steueroberfläche vorgesehen ist, die vor dem Abheben des Bauteils von der Folie unter Aufrechterhaltung des Unterdrucks planparallel zur Stützebene (11) bewegt wird, dadurch gekennzeichnet, dass die Folie an wenigstens einem ebenen Flächenabschnitt (8) auf der Steueroberfläche aufliegt und dass das Bauteil zuerst vom Haltewerkzeug erfasst und bis zum Abheben in jeder Sequenz der Ablösung entweder zwischen der Haltefläche und dem Flächenabschnitt oder zwischen der Haltefläche und dem Stützelement (6) klemmend gehalten wird.

Verfahren nach Absatz [0068], dadurch gekennzeichnet, dass der Flächenabschnitt (8) aus der Stützebene (11) in eine Ablöseposition (X) zurückgezogen wird, während das Haltewerkzeug das Bauteil (1) festhält und dass anschliessend das Bauteil von der noch durch das Stützelement (6) gehaltenen Verbindung mit der Folie abgelöst wird.

Verfahren nach Absatz [0068], dadurch gekennzeichnet, dass der Flächenabschnitt (8) zuerst aus der Stützebene (11) simultan mit dem Haltewerkzeug (4) über die Stützebene hinaus vorgeschoben und wieder in die Stützebene zurückgesetzt wird, dass anschliessend der Flächenabschnitt (8) aus der Stützebene in eine Ablöseposition (X) zurückgezogen wird, während das Haltewerkzeug (4) das Bauteil (1) festhält und dass zuletzt das Bauteil von der noch durch das Stützelement (6) gehaltenen Verbindung mit der Folie abgelöst wird.

Verfahren nach einem der Absätze [0068] bis [0070] , dadurch gekennzeichnet, dass mehrere zueinander beabstandete Flächenabschnitte simultan derart bewegt werden, dass wenigstens zwischen zwei Flächenabschnitten ein Stützelement angeordnet ist.

Verfahren nach einem Absätze [0068] bis [0071], dadurch gekennzeichnet, dass die Abstützung der Folie (2) am Stützelement (6) punktförmig und/oder linienförmig.erfolgt.

Verfahren nach einem der Absätze [0068] bis [0072] , dadurch gekennzeichnet, dass das Bauteil wenigstens zu Beginn des Ablösevorgangs durch den Flächenabschnitt an wenigstens 50% seiner Fläche abgestützt wird.

Verfahren nach einem der Absätze [0068] bis [0073] , dadurch gekennzeichnet, dass der Flächenabschnitt mit einer Heizvorrichtung (40) erwärmt wird.

Verfahren nach einem der Absätze [0068] bis [0074] , dadurch gekennzeichnet, dass die Steueroberfläche bzw. der Flächenabschnitt (8) zu Beginn des Ablösevorgangs etwa in der Stützebene (11) verläuft.

Verfahren nach einem der Absätze [0068] bis [0075] , dadurch gekennzeichnet, dass mehrere Flächenabschnitte (8a, 8b) unabhängig voneinander bewegt werden.

## Patentansprüche

1. Verfahren zum Ablösen eines auf eine flexible Folie (2) geklebten Bauteils (1), insbesondere eines auf eine Waferfolie geklebten Halbleiterchips, wobei das Bauteil an seiner von der Folie abgewandten Oberfläche (3) mit einem Haltewerkzeug (4) an einer ebenen Haltefläche erfasst und von der Folie abgehoben wird, wobei die Folie (2) im Bereich des Bauteils (1) derart auf ein Ablösewerkzeug (5) platziert wird, dass sie in einer Stützebene (11) aufliegt und in der Stützebene durch wenigstens ein Stützelement (6) abgestützt wird, und wobei die Folie mittels Unterdruck sowohl gegen das Stützelement (6), als auch teilweise unter die Stützebene (11) gesaugt wird, **dadurch gekennzeichnet, dass** ferner wenigstens ein Steuerelement (10) mit einer Steueroberfläche vorgesehen ist, die vor dem Abheben des Bauteils von der Folie unter Aufrechterhaltung des Unterdrucks planparallel zur Stützebene (11) bewegt wird, dass die Folie an wenigstens einem ebenen Flächenabschnitt (8) auf der Steueroberfläche aufliegt, und dass das Bauteil zuerst vom Haltewerkzeug erfasst und bis zum Abheben in jeder Sequenz der Ablösung entweder zwischen der Haltefläche und dem Flächenabschnitt oder zwischen der Haltefläche und dem Stützelement (6) klemmend gehalten wird.

2. Verfahren nach Anspruch 1, **dadurch gekennzeichnet, dass** der Flächenabschnitt (8) aus der Stützebene (11) in eine Ablöseposition (X) zurückgezogen wird, während das Haltewerkzeug das Bauteil (1) festhält und dass anschliessend das Bauteil von der noch durch das Stützelement (6) gehaltenen Verbindung mit der Folie abgelöst wird.

3. Verfahren nach Anspruch 1, **dadurch gekennzeichnet, dass** der Flächenabschnitt (8) zuerst aus der Stützebene (11) simultan mit dem Haltewerkzeug (4) über die Stützebene hinaus vorgeschoben und wieder in die Stützebene zurückgesetzt wird, dass anschliessend der Flächenabschnitt (8) aus der Stützebene in eine Ablöseposition (X) zurückgezogen wird, während das Haltewerkzeug (4) das Bauteil (1) festhält und dass zuletzt das Bauteil von der noch durch das Stützelement (6) gehaltenen Verbindung mit der Folie abgelöst wird.

4. Verfahren nach einem der Ansprüche 1 bis 3, **dadurch gekennzeichnet, dass** mehrere zueinander beabstandete Flächenabschnitte simultan derart bewegt werden, dass wenigstens zwischen zwei Flächenabschnitten ein Stützelement angeordnet ist.

5. Verfahren nach einem Ansprüche 1 bis 4, **dadurch gekennzeichnet, dass** die Abstützung der Folie (2) am Stützelement (6) punktförmig und/oder linienförmig erfolgt.

6. Verfahren nach einem der Ansprüche 1 bis 5, **dadurch gekennzeichnet, dass** das Bauteil wenigstens zu Beginn des Ablösevorgangs durch den Flächenabschnitt an wenigstens 50% seiner Fläche abgestützt wird.

7. Verfahren nach einem der Ansprüche 1 bis 6, **dadurch gekennzeichnet, dass** mehrere Flächenabschnitte (8a, 8b) unabhängig voneinander bewegt werden.

8. Vorrichtung zum Ablösen eines auf eine flexible Folie (2) geklebten Bauteils (1), insbesondere eines auf eine Waferfolie geklebten Halbleiterchips, mit einem Haltewerkzeug (4) zum Erfassen des Bauteils an seiner von der Folie abgewandten Oberfläche (3) und zum Abheben von der Folie, mit einem Ablösewerkzeug (5), auf das die Folie (2) im Bereich des Bauteils derart platzierbar ist, dass sie in einer Stützebene (11) aufliegt und in der Stützebene durch wenigstens ein Stützelement (6) abstützbar ist, sowie mit wenigstens einem sich gegen die Stützebene öffnenden Unterdruckkanal (9), wobei im Ablösewerkzeug wenigstens ein Steuerelement (10) mit einer Steueroberfläche derart beweglich gelagert ist, dass die Steueroberfläche aus der Stützebene (11) planparallel verschiebbar ist, **dadurch gekennzeichnet, dass** die Steueroberfläche wenigstens einen ebenen Flächenabschnitt (8) aufweist neben dem wenigstens ein Stützelement angeordnet ist.

9. Vorrichtung nach Anspruch 8, **dadurch gekennzeichnet, dass** der Flächenabschnitt (8) aus der Stützebene (11) in eine Ablöseposition (X) im Abstand zur Stützebene zurückziehbar ist.

10. Vorrichtung nach Anspruch 8 oder 9, **dadurch gekennzeichnet, dass** der Flächenabschnitt (8) über die Stützebene (11) hinaus vorschiebbar ist.

11. Vorrichtung nach einem der Ansprüche 8 bis 10, **dadurch gekennzeichnet, dass** die Steueroberfläche (10) mehrere, zueinander beabstandete Flächenabschnitte (8) aufweist und dass wenigstens zwischen zwei Flächenabschnitten (8a, 8b) ein Stützelement (6) angeordnet ist.

12. Vorrichtung nach Anspruch 11, **dadurch gekennzeichnet, dass** die Flächenabschnitte (8a, 8b) fest miteinander verbunden sind.

13. Vorrichtung nach Anspruch 12, **dadurch gekennzeichnet, dass** die Flächenabschnitte unabhängig voneinander bewegbar sind.

14. Vorrichtung nach einem der Ansprüche 8 bis 13, **dadurch gekennzeichnet, dass** das Stützelement (6) punktförmige und/oder linienförmige Auflagen für die Folie aufweist.

15. Vorrichtung nach Anspruch 14, **dadurch gekennzeichnet, dass** das Stützelement eine Mehrzahl von Stützpyramiden oder Stützkegel aufweist, die matrixartig um den Flächenabschnitt bzw. die Flächenabschnitte angeordnet sind.
